(19) Europäisches Patentamt
European Patent Office
Office européen des brevets

(11) **EP 4 629 738 A1**

(12) **EUROPEAN PATENT APPLICATION**
published in accordance with Art. 153(4) EPC

(43) Date of publication:
**08.10.2025 Bulletin 2025/41**

(21) Application number: **24818514.2**

(22) Date of filing: **24.05.2024**

(51) International Patent Classification (IPC):
*H04W 76/10* (2018.01)

(52) Cooperative Patent Classification (CPC):
**G01R 33/02; H04W 4/029; H04W 76/10**

(86) International application number:
**PCT/CN2024/095242**

(87) International publication number:
**WO 2024/250981 (12.12.2024 Gazette 2024/50)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.06.2023 CN 202310666025**

(71) Applicant: **Huawei Technologies Co., Ltd.
Shenzhen, Guangdong 518129 (CN)**

(72) Inventors:
• **XU, Qiang
  Shenzhen, Guangdong 518129 (CN)**

• **SUN, Junwei
  Shenzhen, Guangdong 518129 (CN)**
• **WU, Wenhao
  Shenzhen, Guangdong 518129 (CN)**
• **LI, Chenhe
  Shenzhen, Guangdong 518129 (CN)**
• **HE, Jianlan
  Shenzhen, Guangdong 518129 (CN)**
• **ZENG, Zhanxiu
  Shenzhen, Guangdong 518129 (CN)**
• **XIAO, Houfei
  Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **METHOD FOR ESTABLISHING MULTI-SCREEN COLLABORATION CONNECTION, SYSTEM, DEVICE, STORAGE MEDIUM, AND CHIP**

(57) This application relates to the field of terminal device technologies, and provides a method and system for establishing a multi-screen collaboration connection, a device, a storage medium, and a chip, to resolve a problem that operations in a connection process are cumbersome and user experience is poor when a terminal device establishes a multi-screen collaboration connection. The method is applied to a first device. A magnetic sensor is disposed on the first device. The method includes: detecting magnetic field strength of a location of the first device by using the magnetic sensor; determining a target device from at least one surrounding second device when the magnetic field strength meets a preset condition, where a magnet is disposed on the second device, and the magnet is capable of affecting magnetic field strength around the second device; and establishing a multi-screen collaboration connection to the target device.

| | |
|---|---|
| A first device detects magnetic field strength of a location of the first device by using a magnetic sensor | S601 |
| The first device determines a target device from at least one surrounding second device when the magnetic field strength meets a preset condition | S602 |
| The first device establishes a connection to the target device | S603 |

FIG. 6

## Description

This application claims priority to Chinese Patent Application No. 202310666025.4, filed with the China National Intellectual Property Administration on June 6, 2023 and entitled "METHOD AND SYSTEM FOR ESTABLISHING MULTI-SCREEN COLLABORATION CONNECTION, DEVICE, STORAGE MEDIUM, AND CHIP", which is incorporated herein by reference in its entirety.

## TECHNICAL FIELD

This application relates to the field of terminal device technologies, and in particular, to a method and system for establishing a multi-screen collaboration connection, a device, a storage medium, and a chip.

## BACKGROUND

With rapid development of terminal devices, different terminal devices may implement multi-device interaction functions such as resource sharing, screen mirroring, and screen extension after establishing a multi-screen collaboration connection.

Currently, different terminal devices may trigger, based on built-in special components (for example, near field communication (near field communication, NFC) sensor chips), establishment of a multi-screen collaboration connection in a natural interaction manner like proximity or OneHop, and a user does not need to manually operate another related control. However, some terminal devices may not be equipped with the special components. Therefore, this type of terminal device usually needs to establish a multi-screen collaboration connection in a conventional manner like code scanning or a wired connection, and cannot achieve a natural interaction effect. Operations in a connection process are cumbersome, and user experience is poor.

## SUMMARY

This application provides a method and a system for establishing a multi-screen collaboration connection, a device, a storage medium, and a chip, to resolve a problem in the conventional technology that operations in a connection process are cumbersome and user experience is poor when a terminal device establishes a multi-screen collaboration connection.

To achieve the foregoing objective, this application uses the following technical solutions.

According to a first aspect, a method for establishing a multi-screen collaboration connection is provided, applied to a first device. A magnetic sensor is disposed on the first device. The method includes: detecting magnetic field strength of a location of the first device by using the magnetic sensor; determining a target device from at least one surrounding second device when the magnetic field strength meets a preset condition, where a magnet is disposed on the second device, and the magnet is capable of affecting magnetic field strength around the second device; and establishing a multi-screen collaboration connection to the target device.

According to the method for establishing a multi-screen collaboration connection provided in this embodiment of this application, a natural interactive connection between the first device and the target device may be implemented by using a general-purpose element (like the magnetic sensor and the magnet) built in the terminal device and by using a change of the magnetic field strength when the devices approach each other as a trigger condition for establishing the multi-screen collaboration connection between the devices. This method can be implemented without a need to additionally dispose a special component, and operations in a connection process are simple, so that user experience can be improved.

In some embodiments, the preset condition includes: the magnetic field strength is greater than a first threshold; or a change rate of the magnetic field strength within a preset time is greater than a second threshold.

In this embodiment, the first threshold and the second threshold are used as a basis for determining whether the magnetic field strength meets the preset condition. If the magnetic field strength meets the preset condition, a process of triggering establishment of the multi-screen collaboration connection is started; or if the magnetic field strength does not meet the preset condition, a process of triggering establishment of the multi-screen collaboration connection is not started, to avoid false triggering.

In some embodiments, determining the target device from the at least one surrounding second device when the magnetic field strength meets the preset condition includes: broadcasting a first indication message when the magnetic field strength meets the preset condition, where the first indication message indicates the second device to send a sounding signal; and determining the target device based on the received sounding signal.

In an example, the first indication message further indicates the second device to send a sounding signal of preset strength, and determining the target device based on the received sounding signal includes: determining signal strength of each received sounding signal; and determining a second device corresponding to a sounding signal whose signal strength is the greatest and is greater than a strength threshold as the target device.

In another example, the first indication message further indicates the second device to send a sounding signal that carries a sending time, and determining the target device based on the received sounding signal includes: determining a receiving time at which each sounding signal is received; determining a distance between the first device and each second device based on the sending time and the receiving time of each sounding signal; and determining, as the target device, a second device whose distance to the first device is the shortest and less than a distance threshold.

In some embodiments, determining the target device from the at least one surrounding second device when the magnetic field strength meets the preset condition includes: broadcasting a third indication message and a sounding signal when the magnetic field strength meets the preset condition, where the third indication message indicates the second device to enable proximity detection, and the proximity detection includes that the second device determines, after receiving the sounding signal, a distance between the second device and the first device based on the sounding signal; receiving at least one feedback signal sent by the at least one second device, where the feedback signal is broadcast after the second device enables the proximity detection, and the feedback signal includes the distance between the second device and the first device; and determining, as the target device based on the at least one feedback signal, a second device corresponding to a feedback signal including a distance that is the shortest and that is less than a distance threshold in the at least one feedback signal.

In this embodiment, after detecting that the magnetic field strength meets the preset condition, the first device starts a detection process of determining the target device from the at least one surrounding second device. Compared with a process in which a target device is determined according to a high-precision proximity detection method like an ultrasonic signal or a UWB pulse signal based on always-on in the conventional technology, the method in this embodiment can accurately determine the target device, reduce false triggering, and further reduce device power consumption.

In some embodiments, after determining the target device from the at least one surrounding second device when the magnetic field strength meets the preset condition, the method further includes: broadcasting a notification message, where the notification message indicates that a corresponding second device becomes the target device.

Optionally, another second device may also determine, based on the notification message, that the another second device is not the target device determined by the first device through identification.

In some embodiments, after broadcasting the notification message, the method further includes: determining first posture information of the first device; broadcasting a second indication message, where the second indication message indicates the target device to send second posture information; receiving the second posture information; and determining, based on the first posture information and the second posture information, that a posture of the first device matches a posture of the target device, where that the posture of the first device matches the posture of the target device includes: a first plane on which the first device is located coincides with, is parallel to, or is perpendicular to a second plane on which the second device is located.

In some embodiments, determining, based on the first posture information and the second posture information, the posture of the first device matches the posture of the target device includes: when an absolute value of a difference between a corresponding angle of the first device and a corresponding angle of the target device is within a first preset range, determining that the first plane on which the first device is located coincides with or is parallel to the second plane on which the second device is located; and/or when the absolute value of the difference between the corresponding angle of the first device and the corresponding angle of the target device is within a second preset range, determining that the first plane on which the first device is located is perpendicular to the second plane on which the second device is located.

In some embodiments, establishing the multi-screen collaboration connection to the target device includes: establishing the multi-screen collaboration connection to the target device when the posture of the first device matches the posture of the target device

In this embodiment, a device posture is used as a prerequisite for triggering establishment of the multi-screen collaboration connection. When there are a plurality of second devices (for example, a mobile phone and a tablet computer), the first device only establishes a multi-screen collaboration connection to a second device that is located in a plane that coincides with, is parallel to, or is perpendicular to the plane on which the first device is located, to improve accuracy of a process of establishing the multi-screen collaboration connection, and avoid false triggering.

In some embodiments, after establishing the multi-screen collaboration connection to the target device, the method further includes: determining the first posture information of the first device; sending a posture information request to the target device, where the posture information request is used to request the target device to send the second posture information; receiving the second posture information; determining a status of posture matching between the first device and the target device based on the first posture information and the second posture information; and triggering a corresponding multi-screen collaboration function when the posture of the first device matches the posture of the target device.

In some embodiments, triggering the corresponding multi-screen collaboration function when the posture of the first device matches the posture of the target device includes: The target device uses an accessory of the first device when the first plane on which the first device is located coincides with or is parallel to the second plane on which the second device is located.

In some embodiments, the method further includes: When the absolute value of the difference between the corresponding angle of the first device and the corresponding angle of the target device is within a third preset range, the target device stops using the accessory of the first device.

In this embodiment, the first device and the target device adjust the multi-screen collaboration function based on the status of posture matching between the first device and the target device for different application scenarios.

In some embodiments, triggering the corresponding multi-screen collaboration function when the posture of the first device matches the posture of the target device includes: using the first device as an external keyboard or an external controller of the target device when the first plane on which the first device is located is perpendicular to the second plane on which the second device is located.

In this embodiment, after establishing the connection to the target device, the first device triggers different functions based on different relative postures between the devices, and implements an interaction manner that is more abundant and natural by using semantics included in device posture information.

According to a second aspect, a system for establishing a multi-screen collaboration connection is provided, including a first device and at least one second device, where a magnetic sensor is disposed on the first device, the first device is configured to perform the method for establishing a multi-screen collaboration connection according to the first aspect, a magnet is disposed on the second device, and the magnet is capable of affecting magnetic field strength around the second device.

According to a third aspect, a terminal device is provided, including a memory, a processor, and a computer program that is stored in the memory and that is capable of being run on the processor. When executing the computer program, the processor implements the method for establishing a multi-screen collaboration connection according to the first aspect.

According to a fourth aspect, a computer-readable storage medium is provided. The computer-readable storage medium stores a computer program. When the computer program is executed by a processor, the method for establishing a multi-screen collaboration connection according to the first aspect is implemented.

According to a fifth aspect, a chip is provided. The chip includes a processor and a memory. The memory stores a computer program. When the computer program is executed by the processor, the method for establishing a multi-screen collaboration connection according to the first aspect is implemented.

It should be understood that, for beneficial effect of the second aspect to the fifth aspect, refer to related descriptions in the first aspect. Details are not described herein again.

## BRIEF DESCRIPTION OF DRAWINGS

FIG. 1A and FIG. 1B are a diagram of a proximity connection between terminals according to an embodiment of this application;

FIG. 2 is a diagram of a system architecture to which a method for establishing a multi-screen collaboration connection according to an embodiment of this application is applicable;

FIG. 3 is a diagram of a structure of a terminal device according to an embodiment of this application;

FIG. 4 is a diagram of a structure of a terminal device according to an embodiment of this application;

FIG. 5 is a diagram of a structure of a terminal device according to another embodiment of this application;

FIG. 6 is a schematic flowchart of a method for establishing a multi-screen collaboration connection according to an embodiment of this application;

FIG. 7 is a diagram of an interaction procedure of a method for establishing a multi-screen collaboration connection according to an embodiment of this application;

FIG. 8 is a diagram of a scenario of a proximity connection between terminals according to an embodiment of this application;

FIG. 9 is a diagram of an interaction procedure of determining, by a first device, whether a posture of the first device matches a posture of a target device according to an embodiment of this application;

FIG. 10 is a diagram of a structure of a device posture according to an embodiment of this application;

FIG. 11 is a diagram of an interaction procedure of a method for establishing a multi-screen collaboration connection according to another embodiment of this application;

FIG. 12A is a diagram of a scenario of screen mirroring between devices according to an embodiment of this application;

FIG. 12B is a diagram of a scenario of screen extension between devices according to an embodiment of this application;

FIG. 12C is a diagram of a scenario of resource sharing between devices according to an embodiment of this application;

FIG. 13 is a diagram of a multi-screen collaboration function selection interface according to an embodiment of this application;

FIG. 14 is a diagram of an interaction procedure of a method for triggering a multi-screen collaboration function based on a device posture according to an embodiment of this application;

FIG. 15 is a diagram of an application scenario of a multi-screen collaboration function according to an embodiment of this application;

FIG. 16 is a diagram of an application scenario of a multi-screen collaboration function according to another embodiment of this application;

FIG. 17 is a diagram of an application scenario of a multi-screen collaboration function according to still another embodiment of this application; and

FIG. 18 is a diagram of a structure of a chip according to an embodiment of this application.

## DESCRIPTION OF EMBODIMENTS

The following describes technical solutions provided in embodiments of this application with reference to the accompanying drawings.

It should be understood that, in descriptions of embodiments of this application, "/" indicates "or", unless otherwise specified. For example, A/B may indicate A or B. The term "and/or" in this specification describes only an association relationship between associated objects, and indicates that three relationships may exist. For example, A and/or B may indicate the following three cases: Only A exists, both A and B exist, and only B exists.

The terms "first" and "second" in embodiments are merely intended for a purpose of description, and shall not be understood as an indication or an implication of relative importance or an implicit indication of a quantity of indicated technical features. Therefore, a feature limited by "first" or "second" may explicitly or implicitly include one or more features.

In the description of embodiments, unless otherwise specified, "a plurality of" means two or more. "At least one of the following" or a similar expression thereof means any combination of these items, including any combination of a single item or a plurality of items. For example, at least one of a, b, or c may represent a, b, c, a and b, a and c, b and c, or a and b and c. Herein, a, b, and c may be singular or plural.

With rapid development of terminal devices, different terminal devices may implement multi-device interaction functions such as screen mirroring, screen extension, and resource sharing after a multi-screen collaboration connection is established between the terminal devices. This interaction manner is efficient and convenient, can implement in-depth interaction across systems and devices, and may be widely applied to the field of terminal devices.

There are a plurality of manners for triggering establishment of a multi-screen collaboration connection between different terminal devices, for example, proximity between devices, code scanning, and wired connection. The manner based on the proximity between devices is convenient and an additional data cable is not required. Therefore, the manner becomes a widely applied trigger manner.

In some embodiments, the proximity between devices includes proximity of Bluetooth (Bluetooth, BT), wireless fidelity (wireless fidelity, Wi-Fi), an ultra-wide band (ultra-wide band, UWB) technology, a special component, and the like. However, when establishment of a multi-screen collaboration connection is triggered by proximity of Bluetooth and Wi-Fi, because ranging precision of Bluetooth and Wi-Fi is too low, an error of 1 m to 2 m usually exists. When the Bluetooth technology or the Wi-Fi technology is used as a trigger condition for proximity between devices, a target device that needs to be approached cannot be accurately determined. However, although positioning precision of the UWB technology is high, power consumption is high, and always-on (always-on) cannot be used. Therefore, a trigger manner of proximity between devices based on a special component is widely applied to triggering a multi-screen collaboration connection between different terminal devices.

Among various special components, a near field communication (near field communication, NFC) sensor chip has been applied to a terminal device due to features of low power consumption, ultra-short working distance (10 cm), and high ranging accuracy.

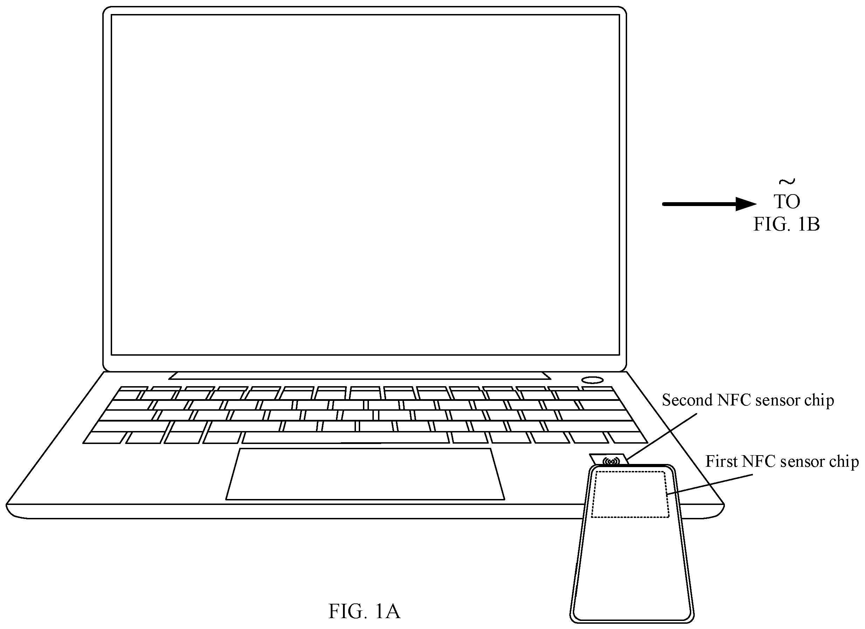

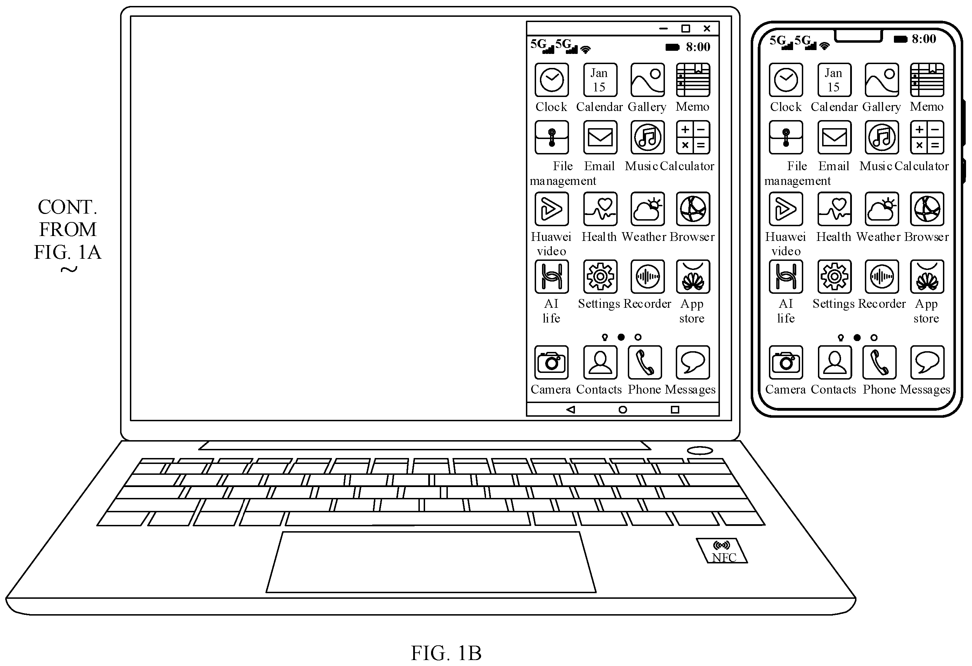

FIG. 1A and FIG. 1B are a diagram of a proximity connection between terminals according to an embodiment of this application, and relates to a process in which a mobile phone and a notebook computer trigger establishment of a multi-screen collaboration connection based on NFC sensor chips. The mobile phone includes a first NFC sensor chip, and the notebook computer includes a second NFC sensor chip. Specifically, a user makes the first NFC sensor chip of the mobile phone be contact with the second NFC sensor chip of the notebook computer. After detecting a radio wave transmitted by the second NFC sensor chip of the notebook computer, the first NFC sensor chip of the mobile phone may read identification information of the notebook computer by using the second NFC sensor chip of the notebook computer, and establish the multi-screen collaboration connection to the notebook computer based on the identification information.

It should be noted that, before the notebook computer and the mobile phone trigger establishment of the multi-screen collaboration connection based on the NFC sensor chips, it needs to be first ensured that WLAN, Bluetooth, and NFC functions of the mobile phone are enabled, the notebook computer supports NFC chip sensing, WLAN, Bluetooth, and PC manager are enabled, and a user license agreement function is agreed, so that a proximity connection between the notebook computer and the mobile phone can be implemented.

Based on the foregoing content, it can be learned that, when establishment of a multi-screen collaboration connection between different devices is triggered based on built-in NFC sensor chips, an NFC sensor chip needs to be disposed on each collaborated terminal device. However, because some terminal devices may not be equipped with the special components, this type of terminal device usually needs to establish a multi-screen collaboration connection in a conventional manner like code scanning and a wired connection, and cannot achieve a natural interaction effect. Operations in a connection process are cumbersome, and user experience is poor.

Therefore, an embodiment of this application provides a method for establishing a multi-screen collaboration connection. In this method, on the basis of a general-purpose element of a terminal device, establishment of a multi-screen collaboration connection is triggered through proximity between a first device with a built-in magnetic sensor and a second device with a built-in magnet, and another special component does not need to be additionally configured. The method not only can be applied to most terminal devices, but also has lower power consumption, simple operation, and better user experience.

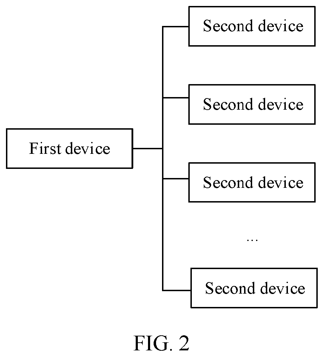

FIG. 2 is a diagram of a system architecture to which a method for establishing a multi-screen collaboration connection according to an embodiment of this application is applicable. With reference to FIG. 2, a system includes a first terminal device (a first device for short) and at least one second terminal device (a second device for short).

It should be noted that, in this embodiment, the first device may have a communication function to communicate with each second device. For example, both the first device and the second device access a WLAN, and both enable Bluetooth. The WLAN accessed by the first device and the second device may be a same network, or may be different networks. The Bluetooth may be classic Bluetooth (Bluetooth, BT), or may be Bluetooth low energy (Bluetooth low energy, BLE).

In this application, the terminal device may be an electronic device like a mobile phone (mobile phone), a tablet computer (Pad), a computer with a wireless transceiver function, a smart television, a wearable device (like a smartwatch), an in-vehicle device, an ultra-mobile personal computer (ultra-mobile personal computer, UMPC), a netbook, or a personal digital assistant (personal digital assistant, PDA). A specific type of the terminal device is not limited in embodiments of this application.

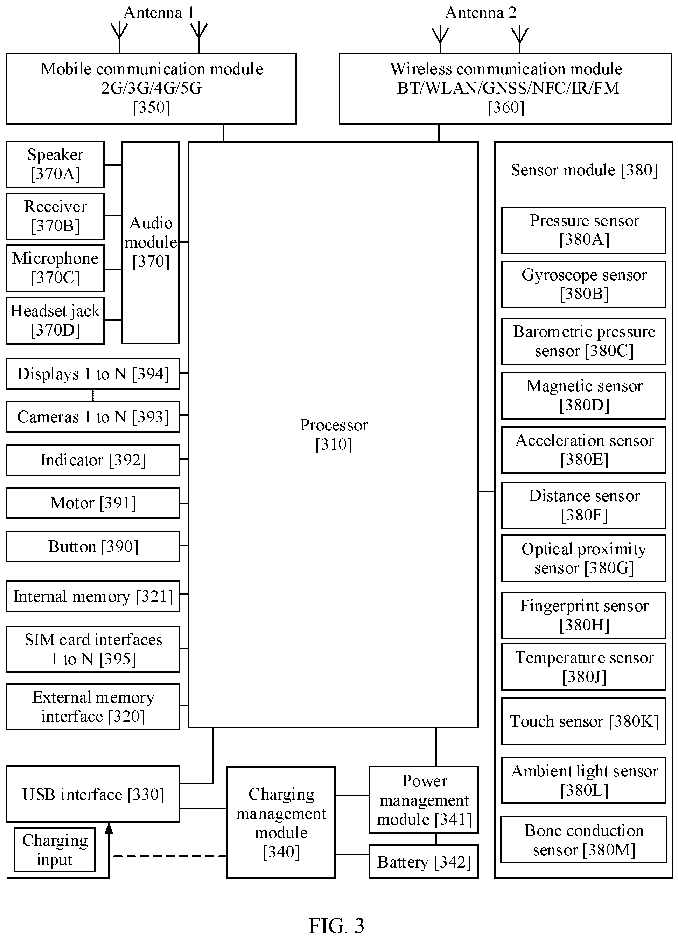

FIG. 3 is a diagram of a structure of a terminal device according to an embodiment of this application. The terminal device may include a processor 310, an external memory interface 320, an internal memory 321, a universal serial bus (universal serial bus, USB) interface 330, a charging management module 340, a power management module 341, a battery 342, an antenna 1, an antenna 2, a mobile communication module 350, a wireless communication module 360, an audio module 370, a speaker 370A, a receiver 370B, a microphone 370C, a headset jack 370D, a sensor module 380, a pressure sensor 380A, a gyroscope sensor 380B, a barometric pressure sensor 380C, a magnetic sensor 380D, an acceleration sensor 380E, a distance sensor 380F, an optical proximity sensor 380G, a fingerprint sensor 380H, a temperature sensor 380J, a touch sensor 380K, an ambient light sensor 380L, a bone conduction sensor 380M, a button 390, a motor 391, an indicator 392, a camera 393, a display 394, a subscriber identification module (subscriber identification module, SIM) card interface 395, and the like.

It can be understood that, a structure illustrated in embodiments of this application does not constitute a specific limitation on the terminal device. In some other embodiments of this application, the terminal device may include more or fewer components than those shown in the figure, or a combination of some components, or splits from some components, or a different component layout. The components shown in the figure may be implemented by using hardware, software, or a group of software and hardware.

For example, when the terminal device is a mobile phone or a tablet computer, the terminal device may include all components shown in the figure, or may include only some components shown in the figure.

The processor 310 may include one or more processing units. Different processing units may be independent components, or may be integrated into one or more processors. A memory may be further disposed on the processor 310, and is configured to store instructions and data. In some embodiments, the memory in the processor 310 is a cache. The memory may store instructions or data just used or cyclically used by the processor 310. If the processor 310 needs to use the instructions or the data again, the processor 310 may directly invoke the instructions or the data from the memory. This avoids repeated access, and reduces waiting time of the processor 310, to improve system efficiency.

The external memory interface 320 may be used to connect to an external memory card, for example, a micro SD card, to extend a storage capability of the terminal device. The external memory card communicates with the processor 310 through the external memory interface 320, to implement a data storage function. For example, files such as music and videos are stored in the external memory card.

The internal memory 321 may be configured to store computer-executable program code, and the computer-executable program code includes instructions. The processor 310 runs the instructions stored in the internal memory 321, to perform various function applications and data processing of the terminal device. The internal memory 321 may include a program storage area and a data storage area. The program storage area may store an operating system, an application required by at least one function (for example, a sound playing function or an image playing function). The data storage area may store data (for example, audio data and an address book) and the like created when the terminal device is used.

In addition, the internal memory 321 may include a high-speed random access memory, and may further include a nonvolatile memory, such as at least one magnetic disk storage component, a flash memory component, and a universal flash storage (universal flash storage, UFS).

The USB interface 330 is an interface that conforms to a USB standard specification, and may be specifically a mini USB interface, a micro USB interface, a USB type-C interface, or the like. The USB interface 330 may be configured to connect to a charger to charge the terminal device, or may be used to transmit data between the terminal device and a peripheral device, or may be configured to connect to a headset for playing audio through the headset. The interface may be further configured to connect to another terminal device, for example, an AR device.

The charging management module 340 is configured to receive a charging input from a charger. The power management module 341 is configured to connect the battery 342 and the charging management module 340 to the processor 310. The power management module 341 receives an input of the battery 342 and/or the charging management module 340, to supply power to the processor 310, the internal memory 321, the external memory, the camera 393, the display 394, the wireless communication module 360, and the like.

A wireless communication function of the terminal device may be implemented by using the antenna 1, the antenna 2, the mobile communication module 350, the wireless communication module 360, a modem processor, a baseband processor, and the like.

The antenna 1 and the antenna 2 are configured to transmit and receive an electromagnetic wave signal. Each antenna in the terminal device may be configured to cover one or more communication frequency bands. Different antennas may be further multiplexed, to improve antenna utilization. For example, the antenna 1 may be multiplexed as a diversity antenna of a wireless local area network. In some other embodiments, the antenna may be used in combination with a tuning switch.

The mobile communication module 350 may provide a wireless communication solution that includes 2G/3G/4G/5G or the like and that is applied to the terminal device. The mobile communication module 350 may include at least one filter, a switch, a power amplifier, a low noise amplifier (low noise amplifier, LNA), and the like. The mobile communication module 350 may receive an electromagnetic wave through the antenna 1, perform processing such as filtering or amplification on the received electromagnetic wave, and transmit the electromagnetic wave to the modem processor for demodulation. The mobile communication module 350 may further amplify a signal modulated by the modem processor, and convert the signal into an electromagnetic wave for radiation through the antenna 1.

In some embodiments, at least some function modules in the mobile communication module 350 may be disposed on the processor 310. In some embodiments, at least some function modules in the mobile communication module 350 may be disposed on a same device as at least some modules in the processor 310.

The modem processor may include a modulator and a demodulator. The modulator is configured to modulate a to-be-transmitted low-frequency baseband signal into a medium-high frequency signal. The demodulator is configured to demodulate a received electromagnetic wave signal into a low-frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal by using an audio device (which is not limited to the speaker 370A, the receiver 370B, or the like), or displays an image or video by using the display 394. In some embodiments, the modem processor may be an independent component. In some other embodiments, the modem processor may be independent of the processor 310, and is disposed in a same component as the mobile communication module 350 or another function module.

The wireless communication module 360 may provide a wireless communication solution that is applied to the terminal device and that includes a wireless local area network (wireless local area network, WLAN) (for example, a wireless fidelity (wireless fidelity, Wi-Fi) network), Bluetooth, a global navigation satellite system (global navigation satellite system, GNSS), frequency modulation (frequency modulation, FM), a near field communication (near field communication, NFC) technology, an infrared (infrared, IR) technology, an ultra-wideband (Ultra-Wideband, UWB) technology, or the like. The wireless communication module 360 may be one or more components integrating at least one communication processor module. The wireless communication module 360 receives an electromagnetic wave through the antenna 2, performs frequency modulation and filtering processing on an electromagnetic wave signal, and sends a processed signal to the processor 310. The wireless communication module 360 may further receive a to-be-sent signal from the processor 310, perform frequency modulation and amplification on the signal, and convert the signal into an electromagnetic wave for radiation through the antenna 2.

In some embodiments, the antenna 1 and the mobile communication module 350 in the terminal device are coupled, and the antenna 2 and the wireless communication module 360 in the terminal device are coupled, so that the terminal device can communicate with a network and another device by using a wireless communication technology.

The terminal device may implement an audio function such as music playing or recording by using the audio module 370, the speaker 370A, the receiver 370B, the microphone 370C, the headset jack 370D, the application processor, and the like.

The audio module 370 is configured to convert a digital audio signal into an analog audio signal for an output, and is also configured to convert an analog audio input into a digital audio signal. The audio module 370 may be further configured to encode and decode an audio signal. In some embodiments, the audio module 370 may be disposed in the processor 310, or some function modules in the audio module 370 are disposed in the processor 310.

The speaker 370A, also referred to as a "loudspeaker", is configured to convert an audio electrical signal into a sound signal. The terminal device may be used to listen to music or answer a call in a hands-free mode over the speaker 370A. In addition, the speaker 370A may further transmit an ultrasonic signal of a preset frequency (for example, $f_1$) under the control of the processor 310.

The receiver 370B, also referred to as an "earpiece", is configured to convert an audio electrical signal into a sound signal. When a call is answered or speech information is received through the terminal device, the receiver 370B may be put close to a human ear to listen to a voice. In addition, the receiver 370B may further transmit an ultrasonic signal of a preset frequency (for example, $f_2$) under the control of the processor 310.

The microphone 370C, also referred to as a "mike" or a "mic", is configured to convert a sound signal into an electrical signal. When making a call or sending voice information, the user may make a sound near the microphone 370C through the mouth of the user, to enter a sound signal to the microphone 370C. At least one microphone 370C may be disposed in the terminal device. In some embodiments, the microphone 370C may further receive an ultrasonic signal, for example, receive ultrasonic signals of different frequencies transmitted by a speaker and a receiver of another terminal device.

The headset jack 370D is configured to connect to a wired headset. The headset jack 370D may be the USB interface 330, or may be a 3.5 mm open mobile terminal platform (open mobile terminal platform, OMTP) standard interface or a cellular telecommunications industry association of the USA (cellular telecommunications industry association of the USA, CTIA) standard interface.

The button 390 includes a power button, a volume button, and the like. The button 390 may be a mechanical button, or may be a touch button. The terminal device may receive a button input, and generate a button signal input related to a user setting and function control of the terminal device.

The motor 391 may generate a vibration prompt. The motor 391 may be configured to provide an incoming call vibration prompt and touch vibration feedback. For example, touch operations performed on different applications (for example, photographing and audio playing) may correspond to different vibration feedback effect. For touch operations performed on different areas of the display 394, the motor 391 may also correspond to different vibration feedback effects. Different application scenarios (for example, a time reminder, information receiving, an alarm clock, and a game) may also correspond to different vibration feedback effects. A touch vibration feedback effect may be further customized.

The indicator 392 may be an indicator light, and may be configured to indicate a charging status and a power change, or may be configured to indicate a message, a missed call, a notification, and the like.

The terminal device implements a display function by using the GPU, the display 394, the application processor, and the like. The GPU is a microprocessor for image processing, and is connected to the display 394 and the application processor. The GPU is configured to: perform mathematical and geometric computation, and render an image. The processor 310 may include one or more GPUs that execute program instructions to generate or change display information.

The display 394 is configured to display an image, a video, and the like. The display 394 includes a display panel. In some embodiments, the terminal device may include one or N displays 394, where N is a positive integer greater than 1.

The SIM card interface 395 is configured to connect to a SIM card. The SIM card may be inserted into the SIM card interface 395 or detached from the SIM card interface 395, to implement contact with or separation from the terminal device. The terminal device may support one or N SIM card interfaces, where N is a positive integer greater than 1.

The terminal device shown in the foregoing embodiment may be the first device, or may be the second device.

When the terminal device is the first device, the first device further includes a magnetic sensor. The magnetic sensor is configured to detect magnetic field strength of a location of the first device. The magnetic field strength is a vector, and is used to describe strength and a direction of a magnetic field. A unit of the magnetic field strength is gauss (Gauss).

In some implementations, the magnetic sensor may be a magnetic field sensor, a Hall effect sensor, or a nine-axis inertia measurement unit (inertial measurement unit, IMU). The nine-axis IMU includes a triaxial accelerometer, a triaxial gyroscope, and a triaxial magnetometer (magnetic sensor, M-Sensor). The triaxial accelerometer is configured to sense acceleration information of a carrier at three degrees of freedom: a pitch (roll) angle, a roll (pitch) angle, or a yawl (yawl) angle. The triaxial gyroscope is configured to sense posture information of the carrier at the three degrees of freedom: the roll angle, the pitch angle, and the yawl angle. The triaxial magnetometer is configured to detect magnetic field strength of a location of the carrier. The magnetic field strength may be a vector sum of magnetic field strength in all directions detected by the triaxial magnetometer, or may be magnetic field strength of the magnetometer at the three degrees of freedom: the roll angle, the pitch angle, and the yawl angle.

Generally, a nine-axis IMU is disposed on a mobile phone. Therefore, the mobile phone may be the first device in this embodiment. In some other implementations, a tablet computer or a notebook computer on which a nine-axis IMU is disposed may also be used as the first device in this embodiment.

When the terminal device is the second device, the second device further includes a magnet, and the magnet is configured to generate a magnetic field.

In some implementations, the magnet may be a magnetic strip or a magnetic element.

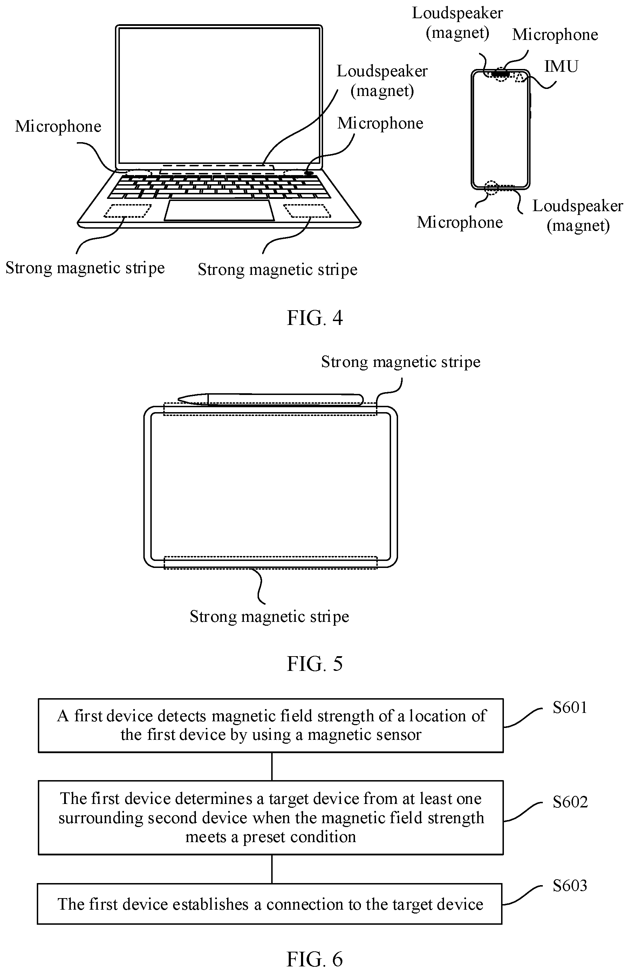

For example, with reference to FIG. 4, a terminal device (like a mobile phone, a tablet computer, and a notebook computer) is equipped with a speaker. Because a sound emitting principle of the loudspeaker is related to a magnet of the speaker, the speaker includes a magnet. Therefore, all terminal devices including a speaker may be used as the second device in this embodiment.

In addition, with reference to FIG. 5, some terminal devices (such as a notebook computer and a tablet computer) usually connect a peripheral device to the terminal devices in a magnetic adsorption manner. For example, the tablet computer adsorbs a stylus on the tablet computer by using a strong magnetic strip disposed on a side of the tablet computer. The strong magnetic strip may also generate a magnetic field. Therefore, the terminal device provided with the strong magnetic strip may also be used as the second device in this embodiment.

In some implementations, when the second device does not include a magnet, a magnetic strip may be attached to a device, and the device to which the magnetic strip is attached is used as the second device.

In still some implementations, when the second device includes an IMU, the second device may determine a device posture by using the IMU. The IMU may be a nine-axis IMU (for details, refer to the foregoing descriptions), or may be an IMU that does not include a magnetometer, for example, a six-axis IMU or a triaxial IMU.

In the system provided in embodiments of this application, the first device may use, as a trigger condition for establishing a multi-screen collaboration connection, a change of magnetic field strength of a location of the first device, and after the magnetic field strength at the location of the first device meets the preset condition, determine a target device from at least one surrounding second device, and establish a connection to the target device.

Based on the system for establishing a multi-screen collaboration connection and the terminal device that are provided in the foregoing embodiments, the following specifically describes the method for establishing a multi-screen collaboration connection provided in the embodiments.

FIG. 6 is a schematic flowchart of a method for establishing a multi-screen collaboration connection according to an embodiment of this application. With reference to FIG. 6, the method may include the following steps S601 to S603.

S601: A first device detects magnetic field strength of a location of the first device by using a magnetic sensor.

The magnetic field strength may be a vector sum of magnetic field strength detected by the magnetic sensor in all directions of the location of the first device, or may be magnetic field strength in a preset direction of the location of the first device. The magnetic field strength may be specifically set based on an actual detection requirement. This is not specifically limited in this embodiment.

In some embodiments, the first device detects the magnetic field strength of the location of the first device in real time by using the magnetic sensor. In this manner, missing detection can be effectively prevented, and a problem that the magnetic sensor cannot detect a change in the magnetic field strength of the location of the first device at a moment can be avoided, so that accuracy of magnetic field strength identification is improved.

In some other embodiments, the first device detects the magnetic field strength of the location of the first device based on the magnetic sensor when the first device is in a specific state like a screen-on state (including a screen-on and screen-locked state and a screen-on and screen-unlocked state). In this manner, power consumption of a device can be effectively reduced, and a service life of the device can be prolonged.

S602: The first device determines a target device from at least one surrounding second device when the magnetic field strength meets a preset condition.

In some embodiments, the preset condition includes that the magnetic field strength is greater than a first threshold. The first threshold may be between 40 gauss and 70 gauss, for example, 50 gauss or 60 gauss. For example, the first threshold is 50 gauss. When the magnetic field strength detected by the first device by using the magnetic sensor is 70 gauss, because the magnetic field strength is greater than the first threshold, it is determined that the magnetic field strength meets the preset condition.

In some other embodiments, the preset condition includes that a change rate of the magnetic field strength within a preset time is greater than a second threshold. It may be understood that, when the change rate is greater than the second threshold, it indicates that the first device and the second device quickly approach each other within a short time (for example, 0.5 seconds). For example, the second threshold may be between 50 gauss and 100 gauss per second, for example, 120 gauss per second or 130 gauss per second.

When the magnetic field strength meets the preset condition, the first device enables a proximity detection function, and determines, from the surrounding second devices, the target device that is closest to the first device and/or whose posture matches a posture of the first device. The proximity detection may be ultrasonic wave-based proximity detection or UWB-based proximity detection. Specific proximity detection and determining processes are described in detail in the following embodiments, and details are not described in this part.

S603: The first device establishes a multi-screen collaboration connection to the target device.

In some embodiments, the first device and the target device establish a communication connection based on respective identification information. The identification information may be a medium access control (medium access control, MAC) address or a device name of the first device or the target device. After establishing the communication connection, the first device and the target device may further establish the multi-screen collaboration relationship.

According to the method provided in this embodiment of this application, a natural interactive connection between the first device and the target device may be implemented by using a general-purpose element (like the magnetic sensor and a magnet) built in the terminal device and by using a change of the magnetic field strength when the devices approach each other as a trigger condition for establishing the multi-screen collaboration connection between the devices. This method can be implemented without a need to additionally dispose a special component, and operations in a connection process are simple, so that user experience can be improved.

In the method for establishing a multi-device collaboration connection provided in this embodiment, the target device may be determined from the surrounding second devices in a plurality of different manners. For example, the first device determines the target device based on a received sounding signal, or the first device determines the target device based on distance information in a feedback signal. The following describes the method provided in this embodiment of this application by using examples with reference to different manners of determining the target device.

**Example 1: The first device determines the target device based on the received sounding signal.**

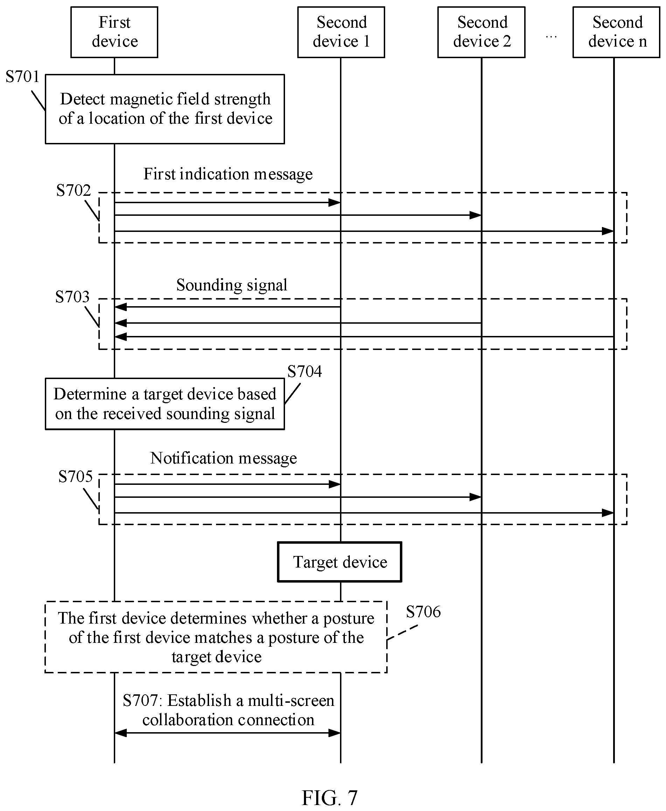

FIG. 7 is a diagram of an interaction procedure of a method for establishing a multi-screen collaboration connection according to an embodiment of this application. With reference to FIG. 7, the method includes the following steps S701 to S707.

S701: A first device detects magnetic field strength of a location of the first device by using a magnetic sensor.

For example, when the first device is a mobile phone, the mobile phone may detect, based on a built-in nine-axis IMU, magnetic field strength of a location of the mobile phone. Generally, a detected value of the magnetic field strength detected by the nine-axis IMU in the mobile phone is a vector sum of magnetic field strength in all directions of the location of the mobile phone. Therefore, the mobile phone may directly determine the detected value as the magnetic field strength of the location of the mobile phone. When the mobile phone uses magnetic field strength in a first direction as the magnetic field strength of the location of the mobile phone, the mobile phone may use the magnetic field strength in the first direction detected by the magnetometer as the magnetic field strength of the location of the mobile phone, where the first direction may be any direction of a magnetometer at three degrees of freedom: a roll angle, a pitch angle, and a yawl angle.

S702: The first device broadcasts a first indication message when the magnetic field strength meets a preset condition.

In some embodiments, the first device may broadcast the first indication message when the magnetic field strength is greater than a first threshold. The first indication message indicates a surrounding second device to transmit a sounding signal. The sounding signal may be an ultrasonic signal or a UWB pulse signal.

A manner in which the first device broadcasts the first indication message may be broadcasting the first indication message to a surrounding device through Bluetooth, or broadcasting the first indication message to a device in a local area network through Wi-Fi. This is not specifically limited in this embodiment.

S703: After receiving the first indication message, the second device transmits the sounding signal.

In some embodiments, the second device may transmit an ultrasonic signal based on a built-in speaker or receiver, or transmit a UWB pulse signal by using a built-in UWB wireless communication module.

In this embodiment, the sounding signal transmitted by the second device carries unique identification information of the second device, where the identification information uniquely indicates a corresponding second device, and the identifier information includes a MAC address and/or a device name of the second device.

In some implementations, after receiving the first indication message, the second device transmits the sounding signal at an interval of a preset time, to prevent a problem that the first device fails to receive the sounding signal due to some reasons after the second device transmits the sounding signal.

S704: The first device determines the target device based on the received sounding signal.

In this embodiment, when the sounding signal is an ultrasonic signal, the first device may receive the sounding signal by using a built-in microphone. When the sounding signal is a UWB pulse signal, the first device may receive the sounding signal by using a built-in UWB wireless communication module.

In some embodiments, when determining the target device, the first device may determine the target device based on strength of the received sounding signal transmitted by each second device. For example, the first device may determine a second device corresponding to a sounding signal whose signal strength is the greatest and is greater than a strength threshold as the target device. The strength threshold may be within a range of 40 dB to 60 dB (decibel, dB) dB, for example, may be 50 dB.

It may be understood that a loss usually exists in a propagation process of the sounding signal, and a longer propagation distance indicates a larger loss and smaller strength of the sounding signal when the first device receives the sounding signal. Therefore, the second device corresponding to the sounding signal that is received by the first device and whose signal strength is the greatest and is greater than a strength threshold is closest to the first device, and is the target device in this application. When the first device determines the target device based on the strength of the sounding signal, the first indication message further indicates the surrounding second device to transmit a sounding signal of preset strength. In other words, sounding signals transmitted by the second device need to maintain consistent strength, so that the first device can determine the target device based on strength of the received sounding signals when receiving the sounding signals. For example, the preset strength may be 60 dB.

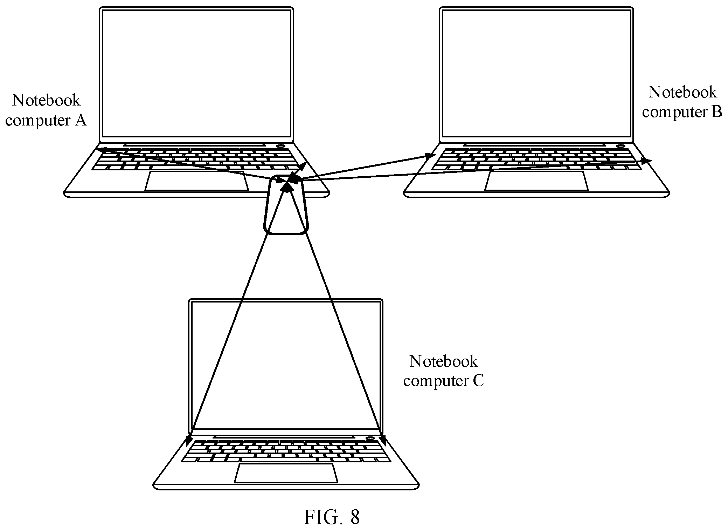

For example, with reference to FIG. 8, the first device is a mobile phone, there are three second devices around the first device, and the second devices are notebook computers. In a process in which the mobile phone determines a target device, the mobile phone detects that strength of a sounding signal of a notebook computer A is 60 dB, detects that strength of a sounding signal of a notebook computer B is 20 dB, and detects that strength of a sounding signal of a notebook computer C is 10 dB. Because the strength of the sounding signal of the notebook computer A is the greatest and exceeds a strength threshold of 50 dB, the mobile phone determines the notebook computer A as the target device.

In some other embodiments, the first device determines a distance between the first device and each second device based on a received sounding signal transmitted by each second device, and then determines a second device, as the target device, including a distance that is the shortest and that is less than a distance threshold. The distance threshold may be within a range of 1 cm to 2 cm, for example, may be 1 cm.

It should be noted that, in this embodiment, the first indication signal further indicates the surrounding second device to transmit a sounding signal that carries timestamp information, where the timestamp information includes a sending time $T_1$ of the sounding signal. After receiving the sounding signal transmitted by each second device, the first device may determine a distance between the first device and each second device based on a sending time $T_1$ and a receiving time $T_2$ of each signal.

For example, with reference to FIG. 8, in a process in which the mobile phone determines the target device based on a distance between the mobile phone and each notebook computer, the mobile phone determines, based on the sounding signal of the notebook computer A, that a distance between the mobile phone and the notebook computer A is 0.5 cm, the mobile phone determines, based on the sounding signal of the notebook computer B, that a distance between the mobile phone and the notebook computer B is 10 cm, and the mobile phone determines, based on the sounding signal of the notebook computer C, that a distance between the mobile phone and the notebook computer C is 15 cm. Because the distance of 0.5 cm between the mobile phone and the notebook computer A is the shortest and the distance is less than a distance threshold of 1 cm, the mobile phone determines the notebook computer A as the target device.

S705: The first device broadcasts a notification message, where the notification message indicates that a corresponding second device becomes the target device.

In this embodiment, the first device may broadcast the notification message to a surrounding device through Bluetooth, or broadcast the notification message to another device in a local area network through Wi-Fi. The notification message may carry identification information of the target device, and the second device that is determined as the target device may determine, after receiving the notification message, that the second device is the target device determined by the first device through identification.

Optionally, another second device may also determine, based on the notification message, that the another second device is not the target device determined by the first device through identification.

For example, after the first device determines a second device 1 as the target device, the first device broadcasts a notification message, where the notification message indicates that the second device 1 becomes the target device. Based on this, after receiving the notification message, the second device 1 determines that the second device 1 is the target device, stops transmitting a sounding signal, and waits to establish a connection to the first device. After receiving the notification message, a second device 2 and a second device 3 determine that the second device 2 and the second device 3 are not the target device, and stop transmitting sounding signals.

S706: The first device determines whether a posture of the first device matches a posture of the target device. If the posture of the first device matches the posture of the target device, a next step S707 is performed.

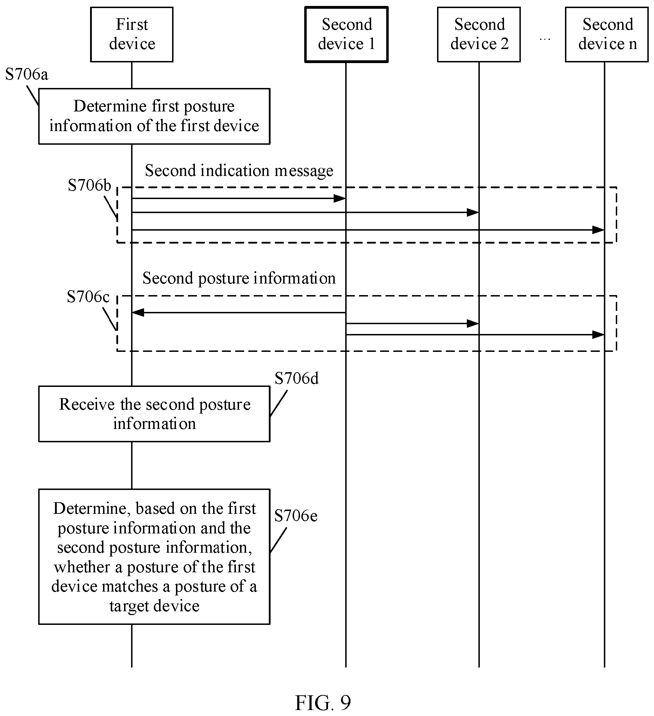

In some embodiments, with reference to FIG. 9, S705 specifically includes the following S706a to S706e.

It should be noted that, in this embodiment, when the first device determines whether the posture of the first device matches the posture of the target device, each of the first device and the target device needs to be provided with a built-in sensor apparatus, for example, an IMU, configured to determine respective posture information. The IMU of the first device may be a nine-axis IMU. A triaxial magnetometer in the nine-axis IMU is configured to detect magnetic field strength of a location of the first device, and a triaxial gyroscope and a triaxial accelerometer are configured to determine posture information of the first device. The IMU built in the second device may be an IMU that does not include a triaxial magnetometer, for example, a triaxial IMU (including a triaxial gyroscope), a six-axis IMU (including a triaxial gyroscope and a triaxial accelerometer), or a nine-axis IMU.

S706a: The first device determines first posture information of the first device.

In this embodiment, the first device may determine the first posture information of the first device based on the built-in nine-axis IMU, where the first posture information indicates the posture of the first device, for example, a landscape orientation or a portrait orientation.

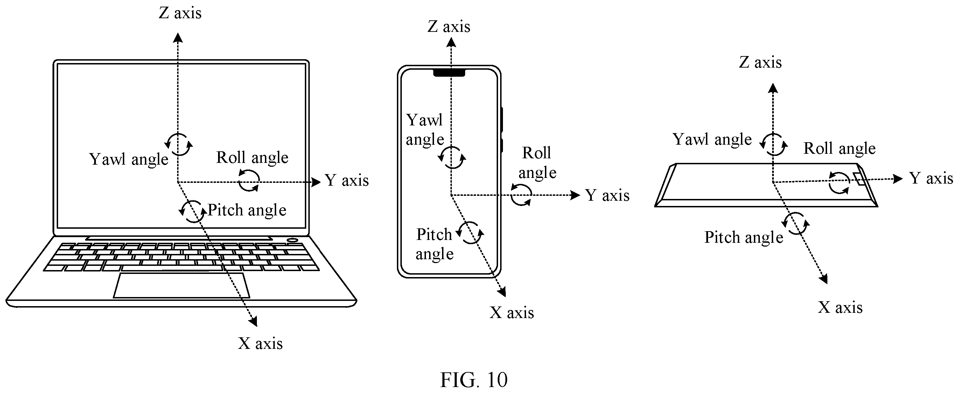

In some embodiments, with reference to FIG. 10, posture information of a device includes angle information of a pitch angle $\alpha$, a roll angle $\beta$, and a yawl angle $\gamma$ of the terminal device.

S706b: The first device broadcasts a second indication message, where the second indication message indicates the target device to send second posture information of the target device.

S706c: The target device sends the second posture information.

For example, after receiving the second indication message, the target device determines the second posture information of the target device by using the built-in sensor apparatus, and then sends the second posture information in a broadcast manner.

S706d: The first device receives the second posture information.

Optionally, the first device may not perform S706b to S706d, and further indicate, based on the first indication message, the second device to send posture information of the second device, to obtain posture information of all second devices, and obtain second posture information of the target device through screening. When the first device further instructs, based on the first indication message, the second device to send the posture information of the second device, the first device directly performs the following step S706e after determining the first posture information of the first device.

S706e: The first device determines, based on the first posture information and the second posture information, whether the posture of the first device matches the posture of the target device.

In this embodiment, that the posture of the first device matches the posture of the target device includes: a first plane coincides with, is parallel to, or is perpendicular to a second plane. For example, the first plane is a plane on which a display of the first device is located, and the second plane is a plane on which a display of the target device is located.

In some embodiments, when an absolute value of a difference between a corresponding angle in the first posture information and a corresponding angle in the second posture information is within a preset range, it is determined that the posture of the first device matches the posture of the target device. The preset range includes a first preset range and a second preset range. The first preset range may be [0°, 5°] or [0°, 10°], and the second preset range may be [85°, 95°] or [90°, 95°].

When the absolute value of the difference between the corresponding angle in the first posture information and the corresponding angle in the second posture information is within the first preset range, for example, [0°, 5°], it indicates that the first plane coincides with or is parallel to the second plane.

When the absolute value of the difference between the corresponding angle in the first posture information and the corresponding angle in the second posture information is within the first preset range, for example, [85°, 95°], it indicates that the first plane is perpendicular to the second plane.

It should be understood that, in this embodiment, the first device and the target device are located in a same Eulerian coordinate system. The following uses a specific example to describe a process in which the first device determines whether the posture of the first device matches the posture of the target device.

For example, with reference to FIG. 8, an example in which the first device is a mobile phone and the target device is a notebook computer A is used. The notebook computer A includes a surface B (a screen area of the notebook computer) and a surface C (a keyboard area of the notebook computer). It is assumed that the IMU is disposed on the surface B of the notebook computer A, a plane on which the mobile phone is located is a first plane, and a plane on which the surface B of the notebook computer A is located is a second plane. In this case, the second posture information determined by the notebook computer A by using the IMU may be represented as ($\alpha_A$, $\beta_A$, $\gamma_A$). The first posture information determined by the mobile phone by using the nine-axis IMU may be represented as ($\alpha$, $\beta$, $\gamma$). The mobile phone compares the second posture information ($\alpha_A$, $\beta_A$, $\gamma_A$) with the first posture information ($\alpha$, $\beta$, $\gamma$) of the mobile phone, and determines an absolute value of a difference of a corresponding angle.

$$\theta_\alpha = |\alpha - \alpha_A|, \ \theta_\beta = |\beta - \beta_A|$$

Herein, $\theta_\alpha$ represents an absolute value of a difference between a tilt angle of the mobile phone and a tilt angle of the notebook computer A, and $\theta_\beta$ represents an absolute value of a difference between a roll angle of the mobile phone and a roll angle of the notebook computer A.

When $\theta_\alpha \in [0°, 5°]$, and $\theta_\beta \in [0°, 5°]$, it is determined that a posture of the mobile phone matches a posture of the notebook computer A, and the plane on which the mobile phone is located is parallel to or coincides with the surface B of the notebook computer A. When $\theta_\beta \in [85°, 95°]$, it is determined that a posture of the mobile phone matches a posture of the notebook computer A, and the plane on which the mobile phone is located is perpendicular to the surface B of the notebook computer A.

It should be noted that step S706 is an optional step. In other words, after determining the target device, the first device may not determine whether the posture of the target device matches the posture of the target device, but directly perform the following step S707.

S707: The first device establishes a multi-screen collaboration connection to the target device.

In some embodiments, the first device and the target device may establish a communication connection based on respective identification information (for example, a MAC address), and then establish the multi-screen collaboration relationship. It may be understood that, after the first device determines the target device, the first device broadcasts the first indication signal, and the target device also determines, based on the first indication signal, that the target device is the target device. Therefore, establishment of the multi-screen collaboration connection may be initiated by the first device, or may be initiated by the target device.

According to the method provided in this embodiment, based on the magnetic sensor built in the first device and the magnet included in the second device, after the magnetic field strength of the location of the first device meets the preset condition, the target device is determined based on the sounding signal, and the multi-screen collaboration connection to the target device is established. This method has advantages of low power consumption and high applicability in addition to implementing a natural interaction connection.

In addition, according to the method for establishing a multi-screen collaboration connection provided in this embodiment, in an embodiment in which a device posture is used as a prerequisite for triggering establishment of a multi-screen collaboration connection, when there are a plurality of second devices (for example, a mobile phone and a tablet computer), the first device only establishes a multi-screen collaboration connection to a second device that is located in a plane that coincides with, is parallel to, or is perpendicular to the plane on which the first device is located, to improve accuracy of a process of establishing the multi-screen collaboration connection, and avoid false triggering.

**Example 2: The first device determines the target device based on the received feedback signal.**

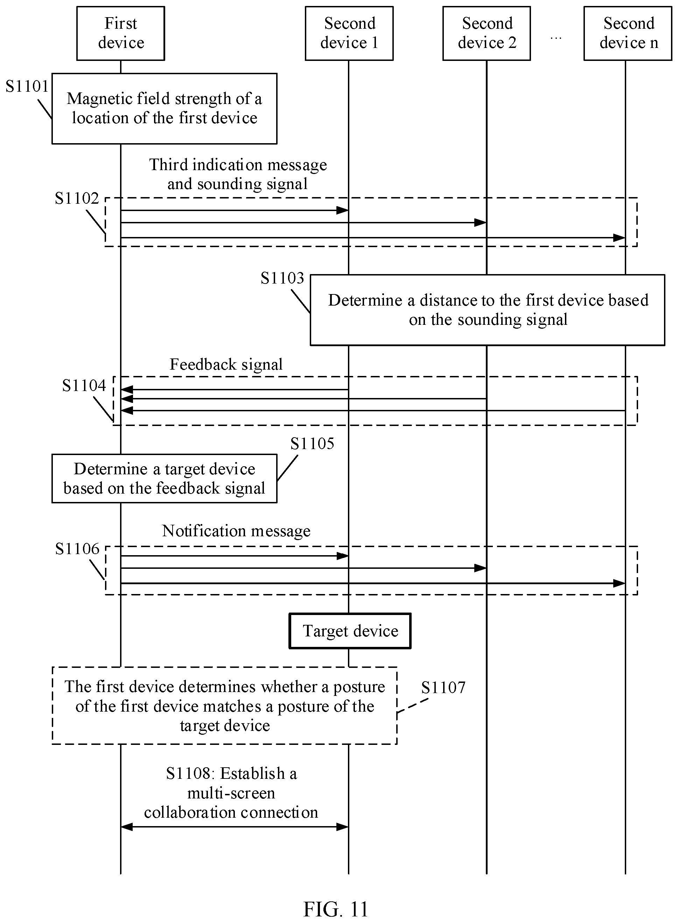

FIG. 11 is a diagram of an interaction procedure of a method for establishing a multi-screen collaboration connection according to another embodiment of this application. With reference to FIG. 11, the method may include the following steps S1101 to S1108.

S1101: A first device detects magnetic field strength of a location of the first device by using a magnetic sensor.

In this embodiment, for specific content of S1101, refer to S701. Details are not described herein again.

S1102: The first device broadcasts a third indication message and sends a sounding signal when the magnetic field strength meets a preset condition.

In this embodiment, the first device broadcasts the third indication message when the magnetic field strength is greater than a first threshold. The third indication message indicates a surrounding second device to enable proximity detection. The proximity detection may be that each second device determines a distance between the second device and the first device based on the received sounding signal. The sounding signal includes an ultrasonic signal or a UWB pulse signal.

In some embodiments, the first device may transmit an ultrasonic signal based on a built-in speaker or receiver, or transmit a UWB pulse signal by using a built-in UWB wireless communication module.

S1103: After receiving the second indication message, the second device determines the distance between the second device and the first device based on the sounding signal.

The second device may receive the ultrasonic signal by using a built-in microphone, or receive the UWB pulse signal by using a built-in UWB wireless communication module.

After the first device broadcasts the third indication message and transmits the sounding signal, the second device that receives the second indication message determines the distance between the second device and the first device based on the received sounding signal.

For example, with reference to FIG. 8, after the mobile phone broadcasts the third indication message and transmits the sounding signal, the notebook computer A, the notebook computer B, and the notebook computer C all determine distances between the mobile phone and the notebook computer A, the notebook computer B, and the notebook computer C based on the sounding signal. The notebook computer 1 determines a first distance between the notebook computer 1 and the mobile phone based on the sounding signal, the notebook computer 2 determines a second distance between the notebook computer 2 and the mobile phone based on the sounding signal, and the notebook computer 3 determines a third distance between the notebook computer 3 and the mobile phone based on the sounding signal.

S1104: The second device broadcasts a feedback signal.

The second device that receives the indication message broadcasts the feedback signal to the first device, where the feedback signal includes distance information between the second device and the first device.

S1105: The first device determines a target device based on the feedback signal.

In some embodiments, after receiving the feedback signal, the first device determines, as the target device based on the distance information in the feedback signal, a second device corresponding to a feedback signal, in the feedback signal, including a distance that is the shortest and that is less than a distance threshold.

S1106: The first device broadcasts a notification message, where the notification message indicates that a corresponding second device becomes the target device.

S1107: The first device determines whether a posture of the first device matches a posture of the target device. If the posture of the first device matches the posture of the target device, a next step S1108 is performed.

In this embodiment, for specific content of S1107, refer to S706. Details are not described herein again.

Similarly, in this embodiment, when the first device determines whether the posture of the first device matches the posture of the target device, each of the first device and the target device needs to be provided with a built-in sensor apparatus configured to determine respective posture information.

It should be noted that, in this embodiment, S1107 is also an optional step. In other words, after determining the target device, the first device may not determine whether the posture of the target device matches the posture of the target device, but directly perform the following step S1108.

S1108: The first device establishes a multi-screen collaboration connection to the target device.

In this embodiment, for specific content of S1108, refer to S707. Details are not described herein again.

It should be noted that, in the foregoing embodiments, each multi-screen collaboration function triggered after the first device establishes the multi-screen collaboration connection to the target device may be set based on an actual requirement. For example, writing may be performed based on a specific operation that can be implemented between different devices (for example, a mobile phone and a notebook computer, a mobile phone and a tablet computer, or a tablet computer and a notebook computer). This is not specifically limited in this embodiment.

In some embodiments, the multi-screen collaboration function includes multi-device interaction functions such as screen mirroring, screen extension, and resource sharing.

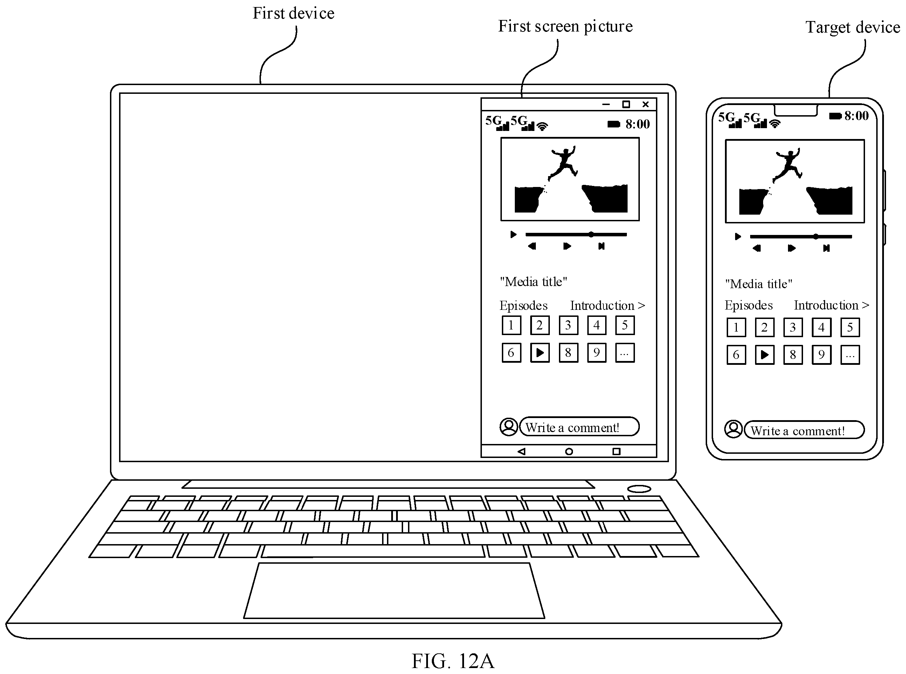

Screen mirroring means that after the first device establishes the multi-screen collaboration connection to the target device, the first device sends a first screen picture of the first device to the target device in real time in a form of a video stream, and the target device displays the first screen picture in real time in a form of a floating window. For details, refer to FIG. 12A. Based on the screen mirroring technology, the first device can be operated and used on an interface of the target device.

For example, after a multi-screen collaboration connection is established between a notebook computer and a mobile phone, a user may use a mouse of the notebook computer to click a picture and music in the mobile phone, so that positioning can be more accurate and faster. Alternatively, the user may use a computer input method to enter a text in a chat window of the mobile phone, so that a typing speed and efficiency can be significantly improved.

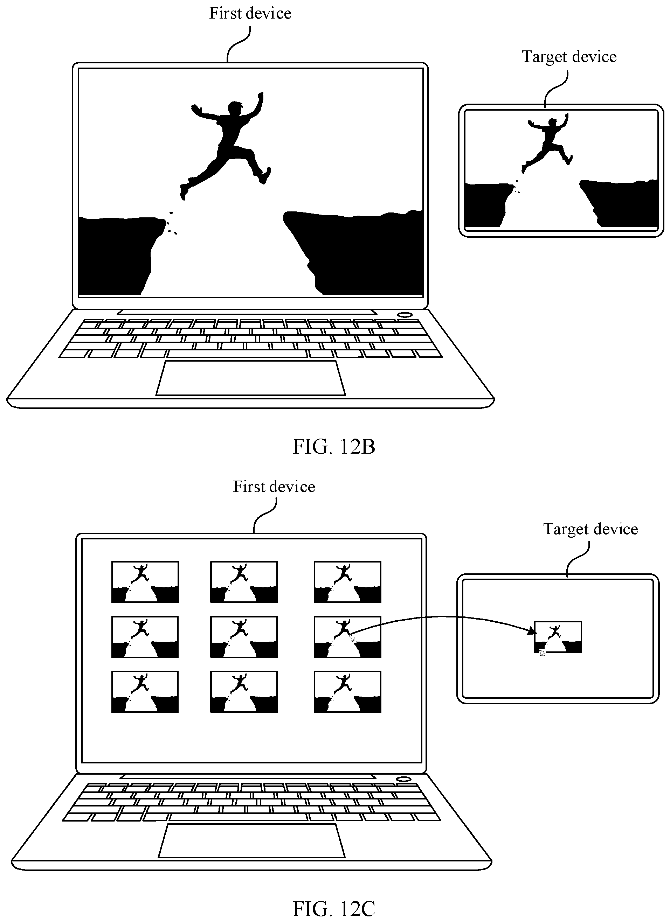

Screen extension means that after the first device establishes the multi-screen collaboration connection to the target device, the target device may be used as an external screen of the first device. For details, refer to FIG. 12B. In the screen extension manner, the first device may move, based on a user operation, target content (like a file, a shortcut icon, a picture, a video, an application icon, or a floating window) on the first device to the target device for display. The user may operate the target content on the target device, for example, open the target content, delete the target content, move the target content, or modify the target content. This is not limited in this embodiment.

Resource sharing means that after establishing the multi-screen collaboration connection to the target device, the first device may share resource information in the first device to the target device based on a user operation. For details, refer to FIG. 12C. The resource information includes but is not limited to a document, a media file (for example, an image, an audio, or a video), a message (for example, a message, an SMS message, or a multimedia message in an instant messaging application), an application installation package, contact information, a web page link, web page content, or other data that can be accessed by a terminal device. This is not limited in embodiments of this application.

It can be learned from the foregoing that, after the first device establishes a connection to the target device, one or more functions are triggered. When one function is triggered, the function may be directly triggered, for example, content displayed on a mobile phone is directly mirrored to a notebook computer. When a plurality of functions are triggered, a selection control of each multi-screen collaboration function may be displayed on a device, and then a corresponding multi-screen collaboration function is started based on a user operation.

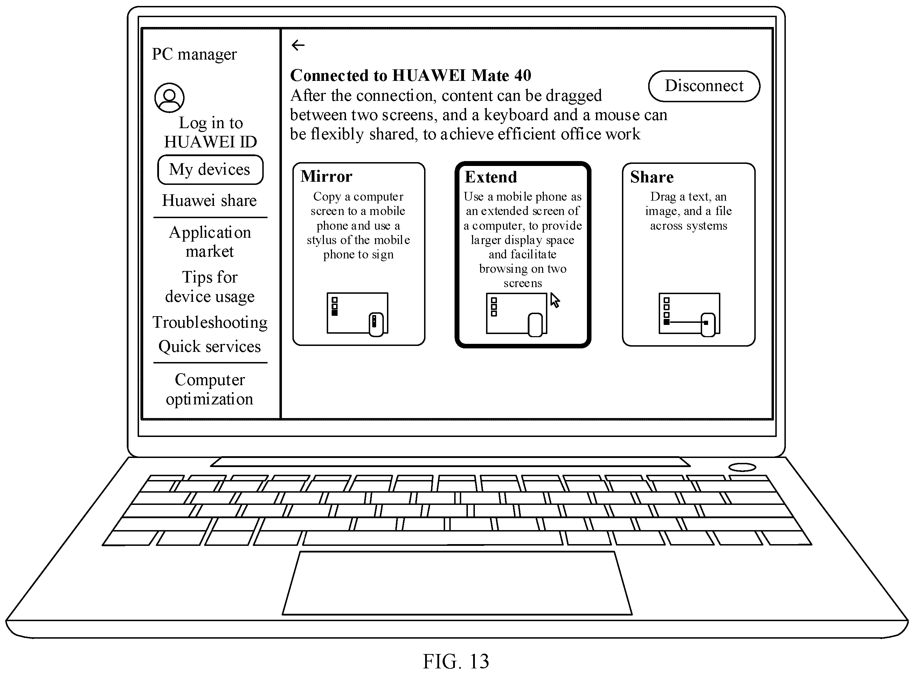

For example, with reference to FIG. 13, after a connection is established between a mobile phone and a notebook computer, the notebook computer displays a selection control, for example, "Mirror", "Extend", and "Share", of each multi-screen collaboration function that can be triggered. In response to a selection operation of a user on the "Extend" selection control, multi-device collaboration between the notebook computer and the mobile phone enters a multi-screen collaboration function of "Extend".

In conclusion, the method for establishing a multi-screen collaboration connection provided in this embodiment is to start high-precision proximity detection based on an ultrasonic signal or a UWB pulse signal after it is detected that magnetic field strength meets a preset condition. Compared with a process in which a target device is determined according to a high-precision proximity detection method like an ultrasonic signal or a UWB pulse signal based on always-on (always-on) in the conventional technology, the method in this embodiment can accurately determine the target device, reduce false triggering, and further reduce device power consumption.

The foregoing is a process of establishing a multi-screen collaboration connection between different terminal devices in different manners provided in this embodiment. In addition, this embodiment further provides a process of triggering a corresponding multi-screen collaboration function based on a device posture after a first device establishes a multi-screen collaboration connection to a target device.

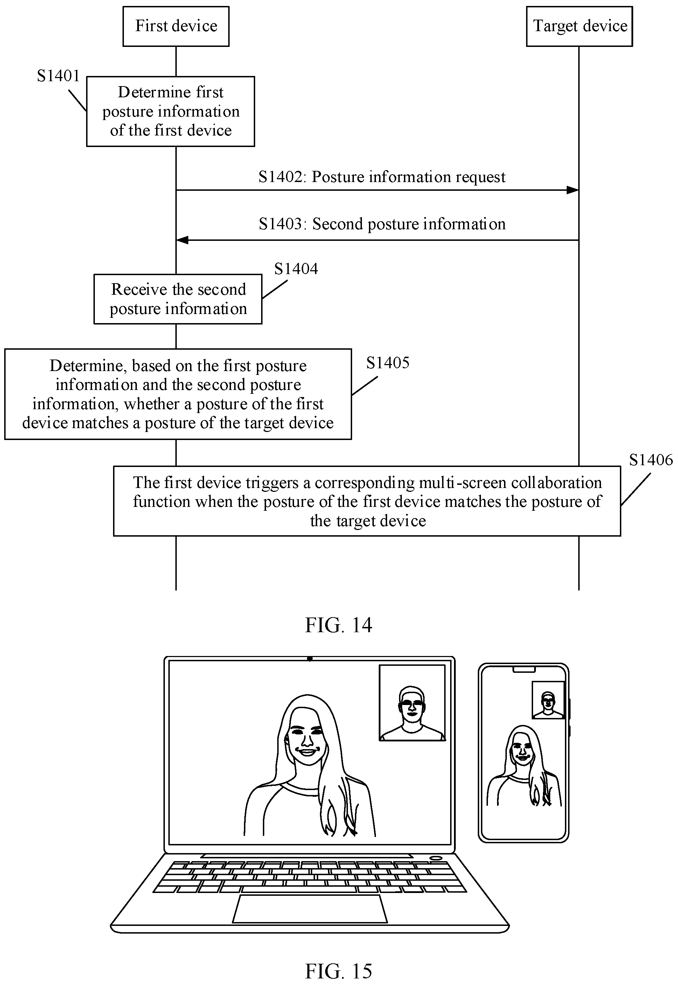

FIG. 14 is a diagram of an interaction procedure of a method for triggering a multi-screen collaboration function based on a device posture according to an embodiment of this application, and relates to a process of triggering a corresponding multi-screen collaboration function based on a device posture after a first device establishes a connection to a target device. It should be noted that, because this embodiment also involves specific steps of performing a corresponding operation based on the device posture, each of the first device and the target device in this embodiment also needs to be provided with a built-in sensor apparatus configured to determine respective posture information. With reference to FIG. 14, the method specifically includes the following steps S1401 to S1406.

S1401: The first device determines first posture information of the first device.

In this embodiment, for specific content of S1401, refer to S706a. Details are not described herein again.

S1402: The first device sends a posture information request to the target device.

The posture information request is used by the target device to send second posture information of the target device to the first device based on the posture information request, where the second posture information indicates a posture of the target device.

S1403: After receiving the posture information request, the target device sends the second posture information of the target device to the first device.

After the first device establishes the connection to the target device, the first device may send the posture information request to the target device through an established connection channel. After receiving the posture information request, the target device sends the second posture information of the target device to the first device through the established connection channel.

S1404: The first device receives the second posture information.

S1405: The first device determines, based on the first posture information and the second posture information, whether a posture of the first device matches the posture of the target device. If the posture of the first device matches the posture of the target device, a next step S1406 is performed.

In this embodiment, for a process in which the first device determines whether the posture of the first device matches the posture of the target device, refer to the foregoing step S706. Details are not described in this part.

S1406: The first device triggers a corresponding multi-screen collaboration function when the posture of the first device matches the posture of the target device.

In this embodiment, different matching forms of the first device and the target device trigger different multi-screen collaboration functions.

It should be noted that, in this embodiment, when the pose status of the first device matches the pose status of the target device, the triggered functions include but are not limited to the screen mirroring, screen extension, resource sharing, and the like shown in the foregoing embodiments, and further include another function triggered based on the device posture.

In some embodiments, when a first plane on which the first device is located is parallel to or coincides with a second plane on which the target device is located, a screen mirroring function is triggered. For example, the first device is a mobile phone, and the target device is a notebook computer. If a first screen picture currently displayed on a screen of the mobile phone is a movie picture, after the mobile phone establishes a multi-screen collaboration connection to the notebook computer, the movie picture of the mobile phone is forwarded to a display interface of the notebook computer in real time, and a user may continue to watch movie content through a screen of the notebook computer.

In some other embodiments, when the first plane on which the first device is located is parallel to or coincides with the second plane on which the target device is located, the triggered multi-screen collaboration function includes another function, for example, the first device uses an accessory (like a camera, a speaker, a microphone, a mouse, and a keyboard) of the target device. For example, the first device is a mobile phone, and the target device is a notebook computer. If a first screen picture currently displayed on a screen of the mobile phone is video chat content, after the mobile phone establishes a multi-screen collaboration connection to the notebook computer, the mobile phone invokes a camera of the notebook computer to continue a current video chat task of the mobile phone, and the user may continue to perform video chat through MeeTime on the notebook computer. For details, refer to FIG. 15.

In a process of implementing camera invoking by the mobile phone and the notebook computer, the mobile phone and the notebook computer are located on a same plane or a similar plane. Because cameras of the two devices have a similar angle of view, video streams can be forwarded without frame freezing during camera switching according to a graphics algorithm.

Compared with a conventional technology in which when a user uses a video chat function of a mobile phone, and a video source needs to be switched from a camera of the mobile phone to a camera of a notebook computer, because shooting angles corresponding to the cameras of the mobile phone and the notebook computer are different, a jump of different angles of view occurs between the camera of the mobile phone and the camera of the notebook computer during video stream forwarding. As a result, frame freezing occurs in a video stream forwarding process, and user experience is affected. The process of triggering a multi-screen collaboration connection provided in this embodiment can implement forwarding of a video stream image without frame freezing, so that user experience is improved.

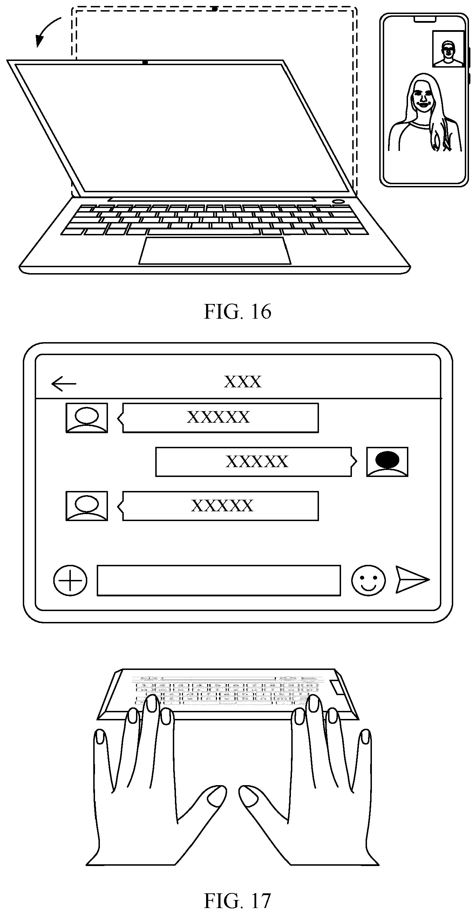

In some other implementations of this embodiment, after the mobile phone establishes the multi-screen collaboration connection to the notebook computer and the first device is triggered to use the multi-screen collaboration function of the accessory of the target device, the mobile phone determines, in real time based on the first posture information of the mobile phone and the second posture information of the notebook computer, whether the posture of the mobile phone matches the posture of the notebook computer. With reference to FIG. 16, when a tilt angle of a screen on a surface B of a notebook computer exceeds a specific angle, a posture of the notebook computer changes, and a screen camera is no longer suitable for being used as a video source of a video chat. Therefore, a mobile phone may trigger a corresponding operation based on changed posture information. For example, when determining that an absolute value of a difference between a corresponding angle of a plane on which the mobile phone is located and a plane on which the plane B of the notebook computer is located is within a third preset range, the mobile phone stops using the screen camera of the notebook computer, and triggers a multi-screen collaboration function of switching the camera of the notebook computer used for video chat to a front-facing camera of the mobile phone. For example, the third preset range may be [65°, 75°], for example, may be 70°.

In still some embodiments, when the first plane on which the first device is located is perpendicular to the second plane on which the target device is located, the triggered multi-screen collaboration function includes another function, for example, the first device is used as an external keyboard or an external controller of the target device. For example, the first device is a mobile phone and the target device is a tablet computer. If the mobile phone determines, based on posture information of the mobile phone and posture information of the tablet computer, that a plane on which the mobile phone is located is parallel to a plane on which the tablet computer is located, a triggered multi-screen collaboration function includes that the mobile phone is used as an external keyboard of the tablet computer or the tablet computer is used as an external keyboard of the mobile phone, as shown in FIG. 17, or the mobile phone is used as an external controller of the tablet computer to control the tablet computer.

In this embodiment, after the first device establishes a connection to the target device, the multi-screen collaboration function is not immediately triggered, but a multi-screen collaboration function corresponding to each posture is triggered only after the posture of the first device and the posture of the target device are determined. In this embodiment, different functions are triggered based on different relative postures between devices, and an interaction manner that is more abundant and natural is implemented by using semantics included in device posture information.

It should be understood that sequence numbers of the steps do not mean execution sequences in the foregoing embodiments. The execution sequences of the processes should be determined based on functions and internal logic of the processes, and should not be construed as any limitation on the implementation processes of embodiments of this application.

An embodiment of this application further provides a terminal device. The terminal device includes a memory, a processor, and a computer program that is stored in the memory and that can run on the processor. When executing the computer program, the processor is configured to implement the method for establishing a multi-screen collaboration connection in the foregoing embodiments.

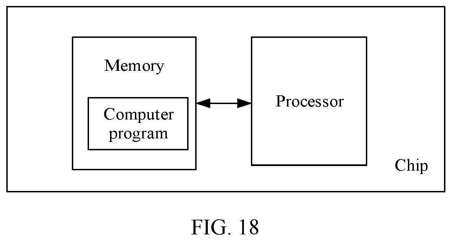

An embodiment of this application further provides a chip. With reference to FIG. 18, the chip includes a processor and a memory. The memory stores a computer program. When the computer program is executed by the processor, the method for establishing a multi-screen collaboration connection in the foregoing embodiments is implemented.

An embodiment of this application further provides a computer-readable storage medium. The computer-readable storage medium stores a computer program. When the computer program is executed by a processor, the method for establishing a multi-screen collaboration connection in the foregoing embodiments is implemented.

An embodiment of this application further provides a computer program product. The program product includes a computer program. When the computer program is run by a terminal device, the terminal device is enabled to perform the method for establishing a multi-screen collaboration connection in the foregoing embodiments.

It should be understood that the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, a discrete hardware component, or the like. The general-purpose processor may be a microprocessor, or the processor may be any conventional processor or the like.

It may be understood that the memory mentioned in embodiments of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM) that is used as an external cache. By way of example, and not limitation, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM).

In embodiments provided in this application, division into the frameworks or modules is merely logical function division and may be other division in actual implementation. For example, a plurality of frameworks or modules may be combined or integrated into another system, or some features may be ignored or not performed.

In addition, function modules in embodiments of this application may be integrated into one processing module, or each of the modules may exist alone physically, or two or more modules are integrated into one module. The integrated module may be implemented in a form of hardware, or may be implemented in a form of a software function module.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

Reference to "one embodiment" or "some embodiments" described in the specification of this application means that one or more embodiments of this application include a specific feature, structure, or characteristic described with reference to the embodiment. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

The foregoing embodiments are merely intended to describe the technical solutions of this application, but are not to limit this application. Although this application is described in detail with reference to the foregoing embodiments, a person of ordinary skill in the art should understand that they may still make modifications to the technical solutions described in the foregoing embodiments or make equivalent replacements to some technical features thereof, without departing from the spirit and scope of the technical solutions of embodiments of this application, and these modifications and replacements shall fall within the protection scope of this application.

**Claims**

1. A method for establishing a multi-screen collaboration connection, wherein the method is applied to a first device, a magnetic sensor is disposed on the first device, and the method comprises:

   detecting magnetic field strength of a location of the first device by using the magnetic sensor;
   determining a target device from at least one surrounding second device when the magnetic field strength meets a preset condition, wherein a magnet is disposed on the second device, and the magnet is capable of affecting magnetic field strength around the second device; and
   establishing a multi-screen collaboration connection to the target device.

2. The method according to claim 1, wherein the preset condition comprises:

   the magnetic field strength is greater than a first threshold; or
   a change rate of the magnetic field strength within a preset time is greater than a second threshold.

3. The method according to claim 1 or 2, wherein determining the target device from the at least one surrounding second device when the magnetic field strength meets the preset condition comprises:

   broadcasting a first indication message when the magnetic field strength meets the preset condition, wherein the first indication message indicates the second device to send a sounding signal; and
determining the target device based on the received sounding signal.

4. The method according to claim 3, wherein the first indication message further indicates the second device to send a sounding signal of preset strength, and determining the target device based on the received sounding signal comprises:

determining signal strength of each received sounding signal; and
determining a second device corresponding to the sounding signal whose signal strength is the greatest and is greater than a strength threshold as the target device.

5. The method according to claim 3, wherein the first indication message further indicates the second device to send a sounding signal that carries a sending time, and determining the target device based on the received sounding signal comprises:

determining a receiving time at which each sounding signal is received;
determining a distance between the first device and each second device based on the sending time and the receiving time of each sounding signal; and
determining, as the target device, a second device whose distance to the first device is the shortest and less than a distance threshold.

6. The method according to claim 1 or 2, wherein determining the target device from the at least one surrounding second device when the magnetic field strength meets the preset condition comprises:

broadcasting a third indication message and a sounding signal when the magnetic field strength meets the preset condition, wherein the third indication message indicates the second device to enable proximity detection, and the proximity detection comprises that the second device determines, after receiving the sounding signal, a distance between the second device and the first device based on the sounding signal;
receiving at least one feedback signal sent by the at least one second device, wherein the feedback signal is broadcast after the second device enables the proximity detection, and the feedback signal comprises the distance between the second device and the first device; and
determining, as the target device based on the at least one feedback signal, a second device corresponding to the feedback signal comprising a distance that is the shortest and that is less than a distance threshold in the at least one feedback signal.

7. The method according to any one of claims 1 to 6, wherein after determining the target device from the at least one surrounding second device when the magnetic field strength meets the preset condition, the method further comprises:
broadcasting a notification message, wherein the notification message indicates that a corresponding second device becomes the target device.

8. The method according to claim 7, wherein after broadcasting the notification message, the method further comprises:

determining first posture information of the first device;
broadcasting a second indication message, wherein the second indication message indicates the target device to send second posture information;
receiving the second posture information; and
determining, based on the first posture information and the second posture information, that a posture of the first device matches a posture of the target device, wherein that the posture of the first device matches the posture of the target device comprises: a first plane on which the first device is located coincides with, is parallel to, or is perpendicular to a second plane on which the second device is located.

9. The method according to claim 8, wherein determining, based on the first posture information and the second posture information, that the posture of the first device matches the posture of the target device comprises:

when an absolute value of a difference between a corresponding angle of the first device and a corresponding angle of the target device is within a first preset range, determining that the first plane on which the first device is located coincides with or is parallel to the second plane on which the second device is located; and/or
when the absolute value of the difference between the corresponding angle of the first device and the corresponding angle of the target device is within a second preset range, determining that the first plane on which the first device is located is perpendicular to the second plane on which the second device is located.

10. The method according to claim 8 or 9, wherein establishing the multi-screen collaboration connection to the target device comprises:
establishing the multi-screen collaboration connection to the target device when the posture of the first device matches the posture of the target device

11. The method according to any one of claims 1 to 10, wherein after establishing the multi-screen collaboration connection to the target device, the method further comprises:

determining the first posture information of the first device;
sending a posture information request to the target device, wherein the posture information request is used to request the target device to send the second posture information;
receiving the second posture information;
determining a status of posture matching between the first device and the target device based on the first posture information and the second posture information; and
triggering a corresponding multi-screen collaboration function when the posture of the first device matches the posture of the target device.

12. The method according to claim 11, wherein triggering the corresponding multi-screen collaboration function when the posture of the first device matches the posture of the target device comprises:
using, by the target device, an accessory of the first device when the first plane on which the first device is located coincides with or is parallel to the second plane on which the second device is located.

13. The method according to claim 12, wherein the method further comprises:
when the absolute value of the difference between the corresponding angle of the first device and the corresponding angle of the target device is within a third preset range, stopping, by the target device, using the accessory of the first device.

14. The method according to claim 11, wherein triggering the corresponding multi-screen collaboration function when the posture of the first device matches the posture of the target device comprises:
using the first device as an external keyboard or an external controller of the target device when the first plane on which the first device is located is perpendicular to the second plane on which the second device is located.

15. A system for establishing a multi-screen collaboration connection, wherein the system comprises a first device and at least one second device, a magnetic sensor is disposed on the first device, the first device is configured to perform the method for establishing a multi-screen collaboration connection according to any one of claims 1 to 14, a magnet is disposed on the second device, and the magnet is capable of affecting magnetic field strength around the second device.

16. A terminal device, comprising a memory, a processor, and a computer program that is stored in the memory and that is capable of being run on the processor, wherein when executing the computer program, the processor implements the method for establishing a multi-screen collaboration connection according to any one of claims 1 to 14.

17. A computer-readable storage medium, wherein the computer-readable storage medium stores a computer program, and when the computer program is executed by a processor, the method for establishing a multi-screen collaboration connection according to any one of claims 1 to 14 is implemented.

18. A chip, wherein the chip comprises a processor and a memory, the memory stores a computer program, and when the computer program is executed by the processor, the method for establishing a multi-screen collaboration connection according to any one of claims 1 to 14 is implemented.

FIG. 1A

TO FIG. 1B

Second NFC sensor chip

First NFC sensor chip

EP 4 629 738 A1

FIG. 1B

```
                              ┌──────────────────┐
                          ┌───┤  Second device   │
                          │   └──────────────────┘
                          │
                          │   ┌──────────────────┐
                          ├───┤  Second device   │
                          │   └──────────────────┘
  ┌──────────────┐        │
  │ First device ├────────┤   ┌──────────────────┐
  └──────────────┘        ├───┤  Second device   │
                          │   └──────────────────┘
                          │
                          │          ...
                          │
                          │   ┌──────────────────┐
                          └───┤  Second device   │
                              └──────────────────┘
```

FIG. 2

Antenna 1                    Antenna 2

| Mobile communication module 2G/3G/4G/5G [350] | Wireless communication module BT/WLAN/GNSS/NFC/IR/FM [360] |

Speaker [370A]

Receiver [370B]

Audio module [370]

Microphone [370C]

Headset jack [370D]

Displays 1 to N [394]

Cameras 1 to N [393]

Indicator [392]

Motor [391]

Button [390]

Internal memory [321]

SIM card interfaces 1 to N [395]

External memory interface [320]

Processor [310]

Sensor module [380]

Pressure sensor [380A]

Gyroscope sensor [380B]

Barometric pressure sensor [380C]

Magnetic sensor [380D]

Acceleration sensor [380E]

Distance sensor [380F]

Optical proximity sensor [380G]

Fingerprint sensor [380H]

Temperature sensor [380J]

Touch sensor [380K]

Ambient light sensor [380L]

Bone conduction sensor [380M]

USB interface [330]

Charging input

Charging management module [340]

Power management module [341]

Battery [342]

FIG. 3

Loudspeaker
(magnet)   Microphone

Loudspeaker
(magnet)                    IMU

Microphone        Microphone

Strong magnetic stripe   Strong magnetic stripe

Microphone        Loudspeaker
(magnet)

FIG. 4

Strong magnetic stripe

Strong magnetic stripe

FIG. 5

| | |
|---|---|
| A first device detects magnetic field strength of a location of the first device by using a magnetic sensor | S601 |
| The first device determines a target device from at least one surrounding second device when the magnetic field strength meets a preset condition | S602 |
| The first device establishes a connection to the target device | S603 |

FIG. 6

EP 4 629 738 A1

FIG. 7

25

Notebook computer A

Notebook computer B

Notebook computer C

FIG. 8

EP 4 629 738 A1

S706a

Determine first posture
information of the first device

First
device

Second
device 1

Second
device 2

Second
device n

...

Second indication message

S706b

Second posture information

S706c

Receive the second posture
information

S706d

Determine, based on the first
posture information and the
second posture information,
whether a posture of the first
device matches a posture of a
target device

S706e

FIG. 9

FIG. 10

| First device | | Second device 1 | Second device 2 | ... | Second device n |
|---|---|---|---|---|---|

S1101 — Magnetic field strength of a location of the first device

Third indication message and sounding signal

S1102

S1103 — Determine a distance to the first device based on the sounding signal

Feedback signal

S1104

Determine a target device based on the feedback signal — S1105

Notification message

S1106

Target device

The first device determines whether a posture of the first device matches a posture of the target device — S1107

S1108: Establish a multi-screen collaboration connection

**FIG. 11**

First device

First screen picture

Target device

"Media title"

Episodes    Introduction >

1  2  3  4  5

6  ▶  8  9  ...

Write a comment!

"Media title"

Episodes    Introduction >

1  2  3  4  5

6  ▶  8  9  ...

Write a comment!

FIG. 12A

EP 4 629 738 A1

FIG. 12B

FIG. 12C

PC manager

Log in to
HUAWEI ID

My devices

Huawei share

Application
market

Tips for
device usage

Troubleshooting

Quick services

Computer
optimization

←

**Connected to HUAWEI Mate 40**
After the connection, content can be dragged
between two screens, and a keyboard and a mouse can
be flexibly shared, to achieve efficient office work

Disconnect

**Mirror**

Copy a computer
screen to a mobile
phone and use a
stylus of the mobile
phone to sign

**Extend**

Use a mobile phone as
an extended screen of
a computer, to provide
larger display space
and facilitate
browsing on two
screens

**Share**

Drag a text, an
image, and a file
across systems

FIG. 13

First device

Target device

S1401 — Determine first posture information of the first device

S1402: Posture information request

S1403: Second posture information

S1404 — Receive the second posture information

S1405 — Determine, based on the first posture information and the second posture information, whether a posture of the first device matches a posture of the target device

S1406 — The first device triggers a corresponding multi-screen collaboration function when the posture of the first device matches the posture of the target device

FIG. 14

FIG. 15

FIG. 16

FIG. 17

FIG. 18

## INTERNATIONAL SEARCH REPORT

| | International application No. |
|---|---|
| | **PCT/CN2024/095242** |

**A.    CLASSIFICATION OF SUBJECT MATTER**

H04W76/10(2018.01)i

According to International Patent Classification (IPC) or to both national classification and IPC

**B.    FIELDS SEARCHED**

Minimum documentation searched (classification system followed by classification symbols)

IPC:H04W,H04Q,H04L

Documentation searched other than minimum documentation to the extent that such documents are included in the fields searched

Electronic data base consulted during the international search (name of data base and, where practicable, search terms used)

CNTXT, WPABS, ENTXTC, CNKI, 3GPP: 多屏, 传屏, 协同, 互动, 投影, 交互, 磁场, 强度, 距离, 姿态, 重合, 平行, 垂直, multiple, transmit, screen, cooperate, interact, projection, magnetic, field, intensity, distance, posture, overlap, parallel, vertical, perpendicular

**C.    DOCUMENTS CONSIDERED TO BE RELEVANT**

| Category* | Citation of document, with indication, where appropriate, of the relevant passages | Relevant to claim No. |
|---|---|---|
| X | US 2021409071 A1 (GOERTEK INC.) 30 December 2021 (2021-12-30) description, paragraphs 28-127 | 1, 7, 15-18 |
| Y | US 2021409071 A1 (GOERTEK INC.) 30 December 2021 (2021-12-30) description, paragraphs 28-127 | 2-6 |
| Y | CN 111522438 A (HUAWEI TECHNOLOGIES CO., LTD.) 11 August 2020 (2020-08-11) description, paragraphs 35-143 | 2 |
| Y | CN 108028797 A (INTEL IP CORP.) 11 May 2018 (2018-05-11) description, paragraphs 62-91 | 3-6 |
| X | CN 115129285 A (HUAWEI TECHNOLOGIES CO., LTD.) 30 September 2022 (2022-09-30) description, paragraphs 46-186 | 1, 7, 15-18 |
| Y | CN 115129285 A (HUAWEI TECHNOLOGIES CO., LTD.) 30 September 2022 (2022-09-30) description, paragraphs 46-186 | 2-6 |
| A | CN 114185503 A (HONOR DEVICE CO., LTD.) 15 March 2022 (2022-03-15) entire document | 1-18 |

☐ Further documents are listed in the continuation of Box C.    ☑ See patent family annex.

| | | |
|---|---|---|
| * | Special categories of cited documents: | "T"   later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X"   document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&"   document member of the same patent family |
| "P" | document published prior to the international filing date but later than the priority date claimed | |

| Date of the actual completion of the international search | Date of mailing of the international search report |
|---|---|
| **22 July 2024** | **23 July 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/095242**

| Patent document cited in search report | | | Publication date (day/month/year) | Patent family member(s) | | | Publication date (day/month/year) |
|---|---|---|---|---|---|---|---|
| US | 2021409071 | A1 | 30 December 2021 | None | | | |
| CN | 111522438 | A | 11 August 2020 | WO | 2021190338 | A1 | 30 September 2021 |
| | | | | US | 2023042460 | A1 | 09 February 2023 |
| | | | | EP | 4116800 | A1 | 11 January 2023 |
| | | | | EP | 4116800 | A4 | 09 August 2023 |
| CN | 108028797 | A | 11 May 2018 | WO | 2017052814 | A1 | 30 March 2017 |
| | | | | US | 2017082724 | A1 | 23 March 2017 |
| | | | | US | 10782385 | B2 | 22 September 2020 |
| | | | | TW | 201721174 | A | 16 June 2017 |
| | | | | TWI | 715605 | B | 11 January 2021 |
| | | | | DE | 112016003501 | T5 | 16 August 2018 |
| | | | | US | 2021055369 | A1 | 25 February 2021 |
| | | | | US | 11719798 | B2 | 08 August 2023 |
| CN | 115129285 | A | 30 September 2022 | None | | | |
| CN | 114185503 | A | 15 March 2022 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310666025